(19) Europäisches Patentamt / European Patent Office / Office européen des brevets

(11) **EP 2 699 881 B1**

(12) **EUROPEAN PATENT SPECIFICATION**

(45) Date of publication and mention
of the grant of the patent:
**04.01.2017 Bulletin 2017/01**

(51) Int Cl.:
*G06F 17/50* (2006.01)  *G01M 5/00* (2006.01)
*G05B 23/02* (2006.01)

(21) Application number: **11715080.5**

(22) Date of filing: **28.02.2011**

(86) International application number:
**PCT/PT2011/000004**

(87) International publication number:
**WO 2012/118390 (07.09.2012 Gazette 2012/36)**

(54) **STRUCTURAL HEALTH MANAGEMENT SYSTEM AND METHOD BASED ON COMBINED PHYSICAL AND SIMULATED DATA**

STRUCTURAL HEALTH MANAGEMENT SYSTEM AND METHOD BASED ON COMBINED PHYSICAL AND SIMULATED DATA

SYSTÈME ET PROCÉDÉ DE GESTION DE SANTÉ STRUCTURELLE EN FONCTION DE DONNÉES PHYSIQUES ET SIMULÉES COMBINÉES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.02.2014 Bulletin 2014/09**

(73) Proprietor: **Critical Materials, Lda.**
**4806-909 Caldas Das Taipas (PT)**

(72) Inventors:
• **MACHADO VIANA, Júlio César**
**P-4750-203 Braga (PT)**
• **RODRIGUES DIAS, Gustavo Alexandre**
**P-4455-139 Matosinhos (PT)**

• **DA ROCHA SOARES ANTUNES, Paulo Jorge**
**P-4715-012 Braga (PT)**
• **VIEIRA BAPTISTA, Manuel Alexandre**
**P-4400-209 Vila Nova de Gaia (PT)**
• **MENDES FERREIRA, Nelson Jadir**
**P-4715-495 Braga (PT)**

(74) Representative: **Ferreira, Maria Silvina**
**Clarke, Modet & Co.**
**Rua Castilho, 50-9°**
**1269-163 Lisboa (PT)**

(56) References cited:
**US-A- 5 210 704      US-A1- 2008 015 827**
**US-A1- 2009 070 048   US-A1- 2010 162 825**
**US-A1- 2010 169 251**

## Description

## Technical field of the invention

The invention relates to structural health monitoring and assessment of structural integrity of critical systems and its management, namely a system and method for these purposes.

## Summary

Specifically, physical sensors (e.g. acceleration, deformation, temperature, humidity) are placed in a structural component/structure using an optimization procedure. The sensors are linked to a data acquisition system, complemented with sampling procedures and signal processing operations. The acquisition system is implemented within an adequate hardware platform (physical module) enabling the storage and low level processing of data. Sensor fault diagnosis is performed to check sensor sanity. The information taken from the physical reality defines an input to a simulated platform (virtual module) that is representative of the behaviour of the component/structure in service. The results of the simulated platform will define a basis for diagnosis of the structural status and provides a mean of structural prognosis, providing a tool for analysing and predicting the structural integrity of the component. This information supports decision-making actions based on the structural health of the critical system and new components/structures design methodologies. Furthermore, the combination of real (from sensor) and simulated data allows of the use of a reduced number of sensors, as simulations are able of giving system response with higher spatial resolution and with additional information. The reduced number of sensors is crucial for a less complex, lightweight and less costly system. The close integration of the invention, between the simulated model, the sensor placement and the real-life system performance monitoring through continuous analysis and update of the previously built simulated model, creates a highly robust, and efficient system whether in terms of sensor placement, sensor malfunction or accuracy of results.

Structural health management can be performed on a single component, single critical system or group of critical systems. It is an object of the invention to provide a new improved system and method as disclosed in the appended claims for the structural health management of critical systems, supporting decisions-making actions thereafter.

The present invention provides a means for diagnosis and prognosis of the structural integrity of components/structures, which can be integrated in maintenance programs enabling maintenance engineers to analyse their structural status and to schedule interventions accordingly, thus reducing costs.

The present invention provides a forecasting tool based on the prognosis of material degradation and evolution of intrinsic damage enabling knowledgeable decisions on repairing and substitution of parts, supporting logistics actions and reducing costs. The structural status prognosis provides also means for better and safer planning of new operations of the critical system.

The present invention provides means for managing the structural health of a set of critical systems, allowing an integrated and more efficient management of a fleet of critical assets.

The present invention provides a means for documenting the loading applied during the lifetime of the component/structure/system and its behaviour. This information is particularly helpful for structural engineers designing of new systems.

Claims 1 to 7 describe different embodiments concerning a system for managing structural health based on combined physical and simulated integrity data of a critical structure (2).

Claims 8 to 15 disclose also different embodiments concerning a method for managing structure health based on combining physical and simulated integrity data of a critical structure (2).

## Background

Within the context of this invention, the expression "critical system" is understood to mean a system or subsystem having one or more mechanical or structural components/structures whose integrity is critical for its performance and safety. Critical systems of this type exist in a great variety of fields, such as for example, the aeronautics, space, maritime, surface transports and infrastructures industries.

Within the context of this invention, the expression "damage diagnostic" is understood to mean the detection of structural or material damage, its location and quantification of its severity.

Modern critical systems are designed within the trade-off of carrying high loads at low weight. Usually the maximum loads and the allowable stresses and strains are defined applying normative instruments that reflect the actual state-of-art of the particular field of structural engineering. Although, significant progress has been done in the near past in design methodologies for advanced materials, the development procedures are based on normative approaches for load determination and analysis followed by large testing programs. Furthermore, even with the previous approach, inspection and maintenance actions are implemented to monitor the structural health of the system, in order to assure high levels of dependability. The maintenance programs are established a priori, based on time estimates and best practices. These often lead to procedures that treat components, which have different importance in the overall behaviour, as equals, with strong impact on the cost of a maintenance program. The normative on the load determination side establishes a safety level that normally collides with a lightweight design of the structure. These norms can be relaxed in the future if there are suitable monitoring procedures that ensure equivalent safety levels. Also suitable monitoring procedures, even when do not imply the relaxation of normative constrains, can be used to extend the inspection intervals on the maintenance programs, with a significant economic impact on the total cost ownership of the critical system.

The monitoring combined with diagnosis and prognosis tools are of paramount importance for critical systems that failure in service would imply its catastrophic collapse. Presently, however, determinations of structural integrity are generally estimated by assuming loading parameters such frequency and maximum loading in order to estimate the structure life. These estimates will generate maintenance protocols, defining inspection intervals and prospective interventions. The inspections are usually performed using interrogation schemes. These are based on procedures of comparing a baseline response representative of a non-degraded behaviour with the actual response, which result is related with the degradation of load carrying capability. Some of these schemes enable the localization of structural flaws and prognostic of residual life. However, an external standard stimulus is needed to load the structure and to compare the response with a baseline solution. More often, for the above mentioned procedure, a sequence of inspection, disassembly, instrumentation and testing tasks are performed. The procedures are valuable for analysis of the structural health, but fail to address an important issue, such as minimizing the necessity of inspections and disassembly operations. Moreover, for the above mentioned procedure, a high number of sensors are installed on the structure/component and excited. This is required in order to have a high spatial resolution and hence a more precise damage diagnostic. This high number of sensors is not compatible with a highly efficient structural health monitoring system, mainly if the sensor network is permanently installed in the structure/component. A high number of sensors, and required cabling, introduces a higher weight into the critical system. A sensor network with a high number of sensors takes more time to install and it is an additional system to inspect and maintain. A high number of sensors generates a high volume of information to process and analyse that may not be relevant in all the cases. A highly efficient structural heath monitoring systems requires therefore the minimal number of sensors.

The present invention provides a new method to analyse the structural health of critical systems, based on a combined approach of physical sensing and simulated modelling and an integrated software tool, directed to overcoming, or at least reducing the effects of one, or more, of the problems set forth above.

Prior health management systems and methods[1] for aircrafts useseveral information sources (from data sources such as data from flight, system performance, physical sensor and built-in-test/built-in-test equipment), a condition analysis and management system for monitoring the data sources, an information controller for acquiring and processing the data sources and a diagnostic/prognostic reasoner for fusing the collected datasources. Diagnostic/prognostic reasoners use only real information sources to indicate faulty conditions of components. Furthermore, these systems only consider a single system/vehicle and do not provide a global overview of the fleet status (diagnostic and prognostic).
[1]EP1455313A1, Sept. 2004 (Kent et al.)

Prior monitoring, diagnosis and prognosis systems and methods[2] use hybrid model-based diagnostic methodologies. Diagnostic is based on a combination of analytical models and graph-based dependency models to enhance diagnostic performance. The adopted model-based method relies on mathematical analytical models mainly derived from a control theory approach and issuitable for fault diagnosis/prognosis. These models, although based on the cause-effect dependences of the system, do not consider the involved physic phenomena related to the behaviour of the material/structure. No simulated data is used. Furthermore, this approach applies only to a single system/vehicle and do not provide a global status overview of a group of systems.
[2]US7260501B2, Aug 2007 (Pattipatti et al.))

Prior structural health management systems of an apparatus[3] (e.g., from aircrafts) use sensor data and baseline comparison approaches (e.g. damage estimate baseline of a component, which can be successively updated) for damage estimation. In this type of data-driven approach no simulated data is used, reducing the information available from the system, and limiting or making cumbersome the structural health diagnosis. Although interfacing with inspection and maintenance systems,this approach applies only to a single system/vehicle and do not provide a global status overview of a group of systems.
[3]US2006/0259217 A1, Nov 2006 (Gorinevsky et al.)

Prior structural health management systems of mobile platforms(e.g., aircraft) include a pre-processor, a structure and a SHM system[4]. Flight parameters and load sensors are used to feed the SHM system that calculates loads. SHM is also able of detecting impacts. The SHM system communicates with a maintenance information system or with an integrated vehicle health management, IVHM, system. The operation of SHM is not detailed, damage diagnostic and prognostic methods not being supported by physical based models or simulated data. Sensors are located arbitrarily near selected components, their position not being optimised. Although interfacing with inspection and maintenance systems and IVHM system, this approach applies only to a single system/vehicle and do not provide a global overview of a group of systems.
[4]US2006/0004499 A1, Jan 2006 (Trego et al.)

In all previous examples, no tool for optimal placement of sensors is adopted. Normally, this requires the use of a high number of sensors or results in less accurate damage diagnosis.In all previous examples, no tool for sensor fault detection is used. Normally, this results in a less accurate damage diagnosis or in a high number of false positives. In all previous examples, no integration of real and simulated data is performed. Normally, this makes difficult an efficient damage diagnosis (damage detection, location and severity) and requires the use of a high number of sensors for improved diagnosis. In all previous examples, structural health management is performed in a single asset/structure and not simultaneously for a set of assets and structures. Normally, this implies a low level of aggregation of information and in a higher difficulty in managing a fleet of assets.In prior structural health management systems, and representatively in all previous examples, no integration of methodologies, methods, algorithms, tools and data is done. Normally, this entails a higher difficulty on deploying and operating a structural health management system. This also entails a less efficient, more difficult and costly management of a fleet of assets. Other examples are disclosed by the documents US2009/0070048, US2010/0162825 and US2010/0169251.

**General Description of the invention**

The present invention relates to a system and method to analyse the structural integrity of critical systems for decision-making support based upon their condition, which is integrated in a structural health management system. The method combines a procedure for reading and analysing information from physical sensors with a simulated computational model of the components/structures of the critical system. The synergy between both real and simulated dataallows for the use of a reduced number of sensors and a more accurate assessment of the health condition of the structure/component. The invention comprises an optimal sensor placement algorithm, a data acquisition system with multi-sensor capability mounted/embedded in the critical system, a sampling algorithm and signal processing operations enabling a balanced and compacted information flow from sensor to storage, a sensor fault detection method, a simulated model of the components/structures combined with the adequate solver for the actual physics involved on the problem, data treatment tools and visualisation, a database tool to store data and manage results with a comprehensive behaviour history, and decision modules for diagnostics and prognostics of the component/structure integrity status. These modules support decision-making actions based on the structural health of the critical system and new components/structures design methodologies. The above referred tools are built-in within one software application enabling the integrated flow of information from physical (on-structure) to simulated (on computer) platforms and an integrated structural health management.

The present invention relates to a structural health management system that integrates in a structured and compacted mode several methods that supports decision-making actions to be taken based upon their structural condition.

A method is provided that enables the analysis of structural health and evaluation of structural integrity of components/structures of critical systems.

This method of analysis is accomplished through the use of information gathered from sensors (physical quantities such as acceleration, deformation, temperature) applied on the critical system and computed data from simulated analysis.

At the design stage of the SHM system, the sensors positions are defined using a suitable optimization methodology that minimizes their number, whilst maximizing their sensing capability. As an example, the sensor placement algorithm can be based on the optimization of the sensor response (e.g., acceleration, strain) over a range of frequencies so they capture the entire/maximum set of vibration modes of the structure. For this, the vibration modes are combined by:

$$U_t = \prod_{mode=1}^{n-1} x_t(m) f(m) . x_t(m+1) f(m+1)$$

where, $U_t$ is the combined positioning variable (e.g., acceleration, strain), m is the mode shape number, $x_t$ is the variable to be monitored, and f are mode shapes weighting functions. The positions of maximum values of $U_t$ are the optimal locations for sensors. Other algorithms for optimal positioning of sensors may be incorporated.

The sensor measurements are channelled through a data acquisition system and recorded for storage. The activation of the acquisition process is controlled by a sampling algorithm and signal processing operations are used to calculate representative values of the variables measured. Sensor fault detection may be performed at the data acquisition level, and warnings/errors will be issued. All the above described features constitute an integrated physical module, enabling the connection with sensors, the recording of values and the interconnection with exterior world.The information gathered is stored on the hardware memory or immediately transmitted for an external data recording hardware. This information can be transferred to a computer using data exchange procedures such cable, wireless or data storage devices (12).

The experimental data received on a computer is translated to a suitable form. Data is further conveniently and adequately processed. Sensor fault detection may be also performed at this level, where warnings/errors are issued. These data may be then used as loading on a representative simulated model of the component/structure. This representative virtual model reconstructs the strain and stress fields for the overall geometry from the load inputs. The experimental data is compared with computed one that, combined with suitable optimization methodology, will allow predicting material degradation and performing the damage diagnostic of the component/structure. A database tool will be used to store the results of the diagnostic of the representative simulated model and it permits a basis for structural prognosis. All the above described features are integrated in a virtual module, supported in a computer application. It enables the connection with the physical world, performing structural health diagnostic and prognostic, data processing and visualization, systems health management and connection with other decision-making support tools.

This approach is not material dependent defining a general method for structural health monitoring.

The method can work in an asynchronous or synchronous mode. In the former case, data is collected in the physical module over a mission or predefined long time period. It is then transferred into the virtual module where several tasks are performed asynchronously (off-time): data monitoring, damage diagnostic and prognostic, and support decision-making actions, as above described. In the second case, data is collected in the physical module during a predefined short time period, therefore in a substantially continuous fashion, being then transferred into virtual module that performs immediately (on-time) data monitoring, damage diagnostic and prognostic, systems health management and support decision-making actions, as above described.

The method can work locally or remotely. In the former case, the physical and virtual modules are both installed in the critical system (on-site). In the second case, the physical module is installed on the critical system (on-system) and the virtual module is located away (off-system) from the critical system (e.g., ground station, control station).

The method can work with in-service excitation of the sensor network coming from the operational use of the system or with an interrogation imposed by a mounted apparatus hat is able of exciting the sensor network. In the former case, the readings from the sensors are taken during operation of the system during its in-service usage. In the second case, the structure/component must be coupled with an excitation apparatus that induces the response of the sensors. The system is loaded when not active in service (static status) by this excitation apparatus. This latter can be of several types: a hammer (instrumented or not) for inducing a local load; an attached mechanical system (mounted actuators instrumented or not) inducing a vibration spectra or a static load (hydraulic, electromechanical; piezoelectric); a blown loading.

The physical module is installed in each critical system, in one or more component!structures/sub-systems. More than one critical system can be deployed. The virtual module can deal with one critical system or a group of critical systems, allowing integrated health management of a set of critical systems.

Typical embodiments of the present inventions can be depicted by aeronautic and energy sector applications. An aircraft represents a critical structural system to manage. This system has several critical structures/components that are crucial for its performance and safety. Illustrative examples of structures/sub=systems are wings andwing box, fuselage, empennage, engines, landing gear. Such structures are composed of critical components and their connections. A set of aeronautic systems can be managed - a part or an entirefleet. In the energy sector, a wind turbine generator represents a critical structural system to manage. This system has several critical structures/components that are crucial for its performance and safety. Illustrative examples of structures are the turbine, nacelle, tower, foundations/footing/mooring structures. Such structures are composed of critical components and their connections (blade, rotor, hub, gearbox, shafts, jacket, pillars, hulls, between others). A set of aeronautic systems can be managed - a part or entire farm.

The various features and advantages of this invention will become apparent to those skilled in structural analysis following the detailed description of the currently preferred embodiment. The drawings that accompany the detailed description will be briefly described as follows.

## Description of the figures

The following figures provide preferred embodiments for illustrating the description and should not be seen as limiting the scope of invention.

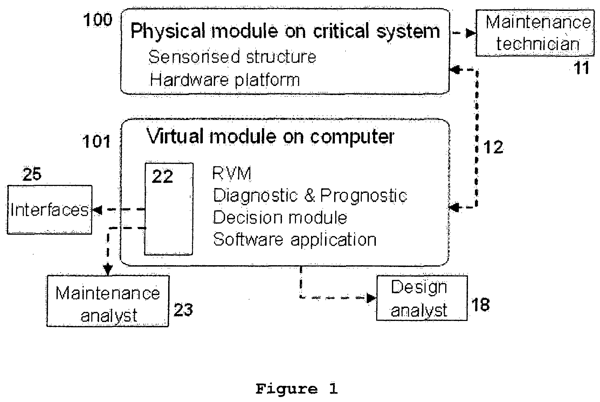

Figure 1 is a schematic representation of the structural health management system and method according with this invention, where:

100 - represents a physical module on critical system, comprising a structure/component instrumented with a multi=sensor network (sensorised structure) and a hardware platform.

101 - represents a virtual module on computer, comprising RVM - representative virtual modules of the structure, methods for optimal positioning of sensors, methods for sensor fault detection, models and methods for damage diagnosis and prognosis,a decision-making support tool, a structural health management tool, a database and a software application.

22 - represents an output layer, comprising a graphical user interface (GUI)

12 - represents a support for data exchange

25 - represents interfaces of (101) with other systems (logistics, maintenance, mission planning)

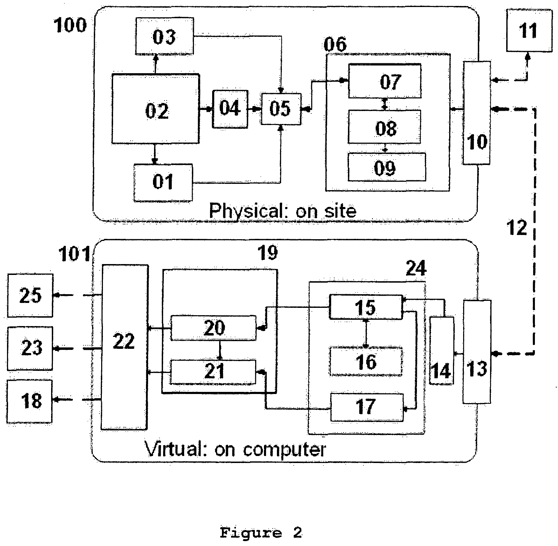

Figure 2 is a detailed schematic representation of the structural health management system and method according with this invention, where:

100 - represents a physical module on critical system, comprising:

01 - a sensor type (acceleration, strain)
02 - a structure to analyse
03 - a sensor type (temperature, humidity)
04 - a sensor type (corrosion, thickness, other)
05 - an interface between the sensors and a data acquisition system
06 - a hardware platform, comprising

07 - a data acquisition system
08 - a sampling algorithm and signal processing tools
09 - a data storage device
10 - a data exchange assess port

12 - represents a data transfer supported by a cable, wireless, portable data storage device connections.
101 - represents a virtual module on computer, comprising:

13 - a data exchange assess port
14 - a data translation
24 - a representative virtual module, RVM, comprising:

15 - a solver
16 - an optimisation tool
17 - a database

19 - a decision module, comprising:

20 - a diagnosis tool
21 - a prognosis tool

22 - an output layer (GUI)

11 - an intervention of a maintenance technician
18 - an intervention of a design analysts
23 - an intervention of a maintenance analyst
25 - an interface with other systems and analysts (logistics, maintenance, mission planning

**Detailed description of the invention**

Referring to Fig. 1 the structural health analysis system is defined by two modules: a physical module 100 and a virtual module 101.
The physical module is located in the critical system. The sensor network is placed on selected components/structures to monitor. The sensors network can be based on commercially off the shelf (COTS) components or on self-sensing materials. The sensors are connected to a data acquisition system (an additional one or supported by an already existing Flight-Data Acquisition Unit - FDUA, or a Supervisory Control and Data Acquisition system - SCADA).The virtual module is located in a computer. It can be placed in the critical system or in another location. A convenient data exchange scheme between the two modules is adopted (cable, wireless or a portable data storage device).
The structural health analysis system can work synchronously, where real and simulated data are combined immediately given the current health status selected of the components/structures. The structural health analysis system can work asynchronously, where real data are collected over a specified time interval (e.g., mission, operation period) and stored. Then, they are transfer to the virtual module, where they are combined with simulated data for giving the health status of selected components/structures.
Referring to Fig. 2 the structural health analysis system is defined by two modules: a physical module 100 and a virtual module 101.
The physical module 100 is materialized on a combination of sensors and a hardware platform. Sensors are installed in specific points of the component or structure 02. The procedure for selection of sensor location points is based on suitable optimization methodologies. Several types of sensors can be used to monitor different physical variables that can be used together or in other configurations. Sensor 01 set is for example defined by thermal probes for the evaluation of the thermal environment of the component. Sensor 03 set is for example defined by strain sensors placed on the structure enabling the local deformation analysis. Sensor 04 set is for example defined by accelerometers for analysing the vibration at specific locations. All sensors are wire or wireless connected to an interface 05 device for data fusion of physical sensors sets. The hardware 06 platform is a scalable platform with the ability to incorporate information from several monitored components and interact with other hardware devices. The hardware 06 platform comprises a signal acquisition system that is wire or wireless connected to the sensor interface 05 device, a configurable firmware 08 that manages the hardware platform defining the sampling pattern for data acquisition and performs signal processing operations on data gathered and a fast storage memory 09 to preserve the information. At this level, simple signal processing operations (e.g., averaging, filtering, time-to-frequency transforms, de-noising) are performed. Sensor fault detection techniques may also be performed at this level that issues warnings about sensor sanity. The hardware 06 platform data can be externally assessed using a data exchange device 10 that enables the interconnection using a portable storage devices or wire and wireless technologies 12.
The virtual module 101 is a computer application. The module comprises three main components a simulation Representative Virtual Model - RVM - 24, a decision module 19 and an output graphical layer 22.

The data obtained from the physical module 100, is an input load for the RVM 24. The module is interconnected using a portable storage devices or wire and wireless technologies 12 and the data is feed to the exchange device 13. The data is transformed through the data translator 14 into a suitable form for direct data input into RVM 24. Before inputting the RVM 24, sensor fault detection techniques are also applied that results in warnings issues about the sensor sanity or may even prevent further calculations. RVM 24 comprises three main elements: i) a numerical solver 15, based on advanced technologies for solving structural dynamics problems; the solver 15 can be based on an analytical or numerical solutions (e.g., Finite Element Method - FEM-, Finite Volume Method - FVM -, Boundary Element Method - BEM - or Meshless technologies); ii) An optimization tool 16 based on optimization methodologies; the optimization tool 16 will interact with solver 15 enabling procedures for earlier sensor placement and damage diagnosis; iii) A database 17 for storage and access of previous information on the systems. The database 17 will permit a starting point for upcoming analysis and a foundation for structure prognosis. The decision module 19 includes two main elements: i) A diagnosis tool 20 that is based on the stress and strain history and materials properties degradation models; the diagnosis tool is a mean to analyse the structural integrity of a component; ii) A prognosis tool 21 to predict the component future behaviour based on the previous RVM results; the information produced for diagnosis and prognosis for a candidate component or substructure can be visualized in an integrated graphical interface output layer 22. The field variables are mapped on the CAD geometry of the structure and the scalar quantities are graphically or numerically displayed, being both also presented in tabular form..

The method to apply the present invention as a structural integrity and health management tool is divided in two phases:

Phase 1: Is associated with design activities of the components/structure of the critical system. The RVM 24 is used by the structural engineer 18 to place optimally a set of sensors on the structure (2). The optimal location and sensor types will be applied to the component. The monitored components/structures are connected to the hardware platform 06 enabling the gathering of data under a predefined sampling pattern. RVM 24 is also integrated on the design process as a plug-in on the analysis tool enabling the analysis of different load scenarios. Structure health condition of the structure (2) can be input in the design analysis from historical, current or predicted data. The information from RVM 24 is also available for the design of new structures/components.

Phase 2: Is associated with operational usage of the structure. The monitored components/structures 02 and the hardware platform 06 are interconnected and during an operational period of the components the sampling algorithm 08 will trigger data gathering intervals, data is read by the data acquisition module 07 being performsignal processing operations 08 before storage for future analysis on the storage device 09. The sampling parameters can be specified by a maintenance technician 11. Periodically the information stored on the hardware platform 06 is feed to the computer application 101. The data is transformed into a suitable form and acts as an input for the RVM 24. RVM will reproduce virtually the mechanical status of the component based on the physical information gathered from with the hardware platform 06. The results from the virtual model will be stored on the database 17 and will be the foundation for mechanical integrity diagnosis 20 of the decision module 19. The prognosis sub-module 21 will use the history of RVM 24 solutions stored on the database 17 as a basis structural health forecast. The diagnosis and prognosis indicators can be displayed for the component in analysis mapped on its geometric representation on the output layer 22. These indicators can be used by the maintenance engineer 23 as a decision support tools for deciding the right schedule for intervention on the structure. For a priori defined maintenance program the maintenance engineer 23 will have a tool that can be used to redefine the intervention calendar and/or typology. The output layer 22 further interfaces with other systems 25. This may be supported by standard communication protocols such as OSA-CBM interface and ISO-13374.

## Claims

1. System for managing structural health, based on combined physical and simulated integrity data, of a critical structure (2) comprising:

   a. a physical module (100) placed in said structure (2), which comprises a sensor network (1,3,4) mounted or embedded in said structure (2) wherein the sensors positions are defined using optimization of the sensor response over a range of frequencies so they capture the maximum set of vibration modes, a hardware platform (6) comprising a data acquisition (7) and sampling and signal processing (8) sub-modules with multi-sensor capability, and an interface (5) to the hardware platform (6);
   b. a virtual module (101), which comprises a simulated representative virtual model (24) of the structure (2) combined with a suitable solver (15) able to reproduce the behaviour of the structure (2), and its components, based on the physical information gathered from the physical module (100);

   wherein the sampling sub-module (8) is

configured to trigger data gathering intervals and data acquisition frequency, based on predefined values or on a sporadic but relevant event.

2. System according to claim 1 further comprising:

    a. a data storage sub-module (9) in the physical module (100);
    b. a database (17) in the virtual module (101) configured to store and manage data, real or simulated;
    c. a decision sub-module (19) comprising diagnostics (20) and prognostics (21) sub-modules of the structure (2).

3. System according to any previous claim wherein signal processing operations are able to be performed in the sampling sub-module (8), in particular averaging, filtering, time-to-frequency transforms, or denoising.

4. System according to any previous claim wherein both physical (100) and virtual (101) modules are both mounted or embedded in said structure (2) and connected by a suitable data connection (12).

5. System according to any previous claim wherein the virtual module (101) is mounted away from said structure (2), and connected to the physical (100) module by a suitable data connection (12).

6. System according to any previous claim wherein the data connection (12) between the physical (100) and virtual (101) modules is asynchronous.

7. System according to any previous claim further comprising the integrated and simultaneous management of the structural health of a set of critical systems.

8. Method for managing structure health based on combining physical and simulated integrity data of a critical structure (2) comprising the steps of:

    a. acquiring sampling and signal processing physical integrity data from a physical module (100) comprising a sensor network (1,3,4) mounted or embedded in said structure (2) wherein the sensors positions are defined using optimization of the sensor response over a range of frequencies so they capture the maximum set of vibration modes, a hardware platform (6) comprising a data acquisition (7) and sampling and signal processing (8) sub-modules with multi-sensor capability, and an interface (5) to the hardware platform (6);
    b. calculating and solving, with a virtual module (101) combined with a solver (15), a simulated

representative virtual model (24) of the structure (2) reproducing the physical status of the structure (2), and its components;
    c. combining real data from the two previous steps through an optimization algorithm of the virtual module (101) for diagnosing - detecting, locating and evaluating the severity - of material or structure damage,

wherein real sensor (1, 3, 4) responses are checked for sensor fault detection before being fed to the simulated virtual model (24),
wherein said simulated model (24) was previously established when defining the optimal locations of said sensors (1,3,4); wherein the sampling sub-module (8) triggers data gathering intervals and data acquisition
frequency, based on predefined values or on a sporadic but relevant event.

9. Method according to claim 8 further comprising the steps of:

    a. storing (9) the acquired (7) and sampled (8) data;
    b. detecting sensor malfunctions and damages in the physical module (100) at the data acquisition level (7) or/and at the virtual module (101) at the data translation level (14), before inputting data into the RVM sub-module (24);
    c. translating, to a suitable format for input into the simulated model (24), the acquired (7), sampled (8) and verified data;
    d. determining diagnosis (20) and prognosis (21) of the structure (2) based on said simulated model (24);
    e. outputting (22) said diagnostics (20) and prognostics (21) of the structure (2).

10. Method according to any previous claims 8 and 9 wherein the sampling sub-module (8) will trigger data gathering intervals and data acquisition frequency, based on predefined values.

11. Method according to any previous claims 8 - 10 wherein the sampling sub-module (8) will trigger data gathering intervals based on relevant events.

12. Method according to any previous claims 8 - 11 wherein simple signal processing operations are performed in the sampling sub-module (8), in particular averaging, filtering, time-to-frequency transforms, de-noising.

13. Method according to any previous claims 8 - 12 wherein a sensors fault detection tool is used for checking sensor sanity, issuing warnings or stopping further actions in the case of sensor malfunctioning.

**14.** Method according to any previous claims 8 - 13 wherein the data communication (12) between the acquired (7) and sampled (8) physical data and the representative virtual model (24) of the structure (2) is asynchronous, with said physical data being collected in data storage (9) over a mission or predefined time period and then being transferred into the simulated model (24).

**15.** Method according to any previous claims 8 - 14 wherein an integrated and simultaneously management of the structural health of several structures/components of a critical system is performed.

**Patentansprüche**

**1.** System zur Verwaltung der Gesundheitsstruktur anhand von physisch kombinierten und simulierten Integritätsdaten von einer kritischen Struktur (2) umfassend:

a. ein physisches Modul (100) gestellt in genannte Struktur (2), das ein Netzwerksensor (1,3,4) eingebaut oder gelagert in genannte Struktur (2) umfasst, worin die Sensorpositionen durch Anwendung von der optimierten Sensorreaktion über eine Reihe von Frequenzen bestimmt sind, so dass sie die maximale Menge der Schwingungsmodi, eine Hardwareplattform (6) die aus einer Datenerfassung (7) besteht und Proben nimmt von und Signale verarbeitet (8) von Submodulen mit Multi-Sensor-Funktion, und eine Anschlussstelle (5) zur Hardwareplattform (6) erfassen;
b. ein virtuelles Modul (101), das ein simuliertes, darstellend virtuelles Modell (24) der Struktur (2) umfasst, kombiniert mit einem geeigneten Löser (15), fähig das Verhalten der Struktur (2) wiederzugeben, und seine Komponente anhand der physischen Information gesammelt vom physischen Modul (100);

worin das Probesubmodul (8) gestaltet ist, um Daten auszulösen durch Ansammlung von Intervallen und Datenerfassungsfrequenz, anhand von vordefinierten Werten oder von einem sporadischen, jedoch relevanten Ereignis.

**2.** System gemäß Anspruch 1 weiter umfassend:

a. ein Datenspeichersubmodul (9) im physischen Modul (100);
b. eine Datenbank (17) im virtuellen Modul (101) gestaltet, um Daten real oder simuliert zu speichern und zu verwalten:
c. ein Entscheidungssubmodul (19), das Diagnose- (20) und (21) Prognosesubmodule der Struktur (2) umfasst.

**3.** System gemäß einem vorigen Anspruch, worin Signalverarbeitungsoperationen fähig sind, im Probesubmodul (8) insbesondere durchschnittliche, filternde oder entlärmende Zeit-Frequenz-Transformationen durchgeführt zu werden.

**4.** System gemäß einem vorigen Anspruch, worin beide physischen (100) und virtuellen (101) Module in genannte Struktur (2) beide eingebaut oder gelagert und durch eine geeignete Datenverbindung (12) verbunden sind.

**5.** System gemäß einem vorigen Anspruch, worin das virtuelle Modul (101) von genannter Struktur (2) entfernt eingebaut und an das physische (100) Modul durch geeignete Datenverbindung (12) verbunden ist.

**6.** System gemäß einem vorigen Anspruch, worin die Datenverbindung (12) zwischen den physischen (100) und virtuellen (101) Modulen asynchron ist.

**7.** System gemäß einem vorigen Anspruch weiter umfassend die integrierte und gleichzeitige Verwaltung der Gesundheitsstruktur von einer Reihe von kritischen Systemen.

**8.** Methode zur Verwaltung der Gesundheitsstruktur anhand von Verbindung physischer und gleichzeitiger Integritätsdaten einer kritischen Struktur (2) umfassend die Schritte:

a. Erfassung, Probenahme und Signalverarbeitung der physischen Integritätsdaten eines physischen Moduls (100), das ein Netzwerksensor (1,3,4) eingebaut oder gelagert in genannter Struktur (2) umfasst, worin die Sensorpositionen durch Nutzung der optimierten Sensorreaktion über eine Reihe von Frequenzen definiert sind, um die maximale Menge von Schwingungsmodi einzufangen, eine Hardwareplattform (6), die eine Datenerfassung (7) und Probenahme und Signalverarbeitung (8) von Submodulen mit Multi-Sensor-Fähigkeit umfasst, und eine Anschlussstelle (5) zur Hardwareplattform (6);
b. Berechnen und Lösen, mit einem virtuellen Modul (101) kombiniert mit einem Löser (15), von einem simulierten, darstellend virtuellen Modell (24) der Struktur (2), die einen physischen Status der Struktur (2) wiedergibt, und seine Komponente;
c. Kombination von realen Daten der zwei vorigen Schritte durch einen optimierten Algorithmus des virtuellen Moduls (101) zur Diagnostizierung -
Erkennung, Orten und Bewerten des Ernstfalles - des Material- oder Strukturschadens,

worin reale Sensorreaktionen (1,3,4) auf Sensorfehlfeststellung geprüft werden, bevor sie dem simulierten virtuellen Modell (24) gefüttert werden,
worin genanntes simuliertes Modell (24) vorher festgesetzt wurde bei Definierung der optimalen Stellen von genannten Sensoren (1,3,4); worin das Probesubmodul (8)
Daten auslöst beim Sammeln der Intervalle und Frequenzdatenerfassung, anhand von vordefinierten Werten oder von einem sporadischen, aber relevanten Ereignis.

9. Methode gemäß Anspruch 8 weiter umfassend die Schritte:

    a. Speichern (9) der erfassten (7) und geprobten (8) Daten;
    b. Feststellung der Sensorfunktionsstörungen und -schäden im physischen Modul (100) am Datenerfassungslevel (7) oder/und am virtuellen Modul (101) am Datenübertragungslevel (14) vor Dateneingabe ins RVM-Submodul (24);
    c. Übersetzung der erfassten (7), geprobten (8) und überprüften Daten in einem geeigneten Format zur Eingabe ins simulierte Modell (24);
    d. Festlegung der Diagnose (20) und Prognose (21) der Struktur (2) anhand von genanntem simulierten Modell (24);
    e. Ausgabe (22) von genannter Diagnose (20) und Prognose (21) der Struktur (2).

10. Methode gemäß einer der Ansprüche 8 und 9, worin das Probesubmodul (8) Daten durch Ansammlung von Intervallen und Datenerfassungsfrequenz auslösen wird anhand von vordefinierten Werten.

11. Methode gemäß einer der Ansprüche 8 - 10, worin das Probesubmodul (8) Daten durch Ansammlung von Intervallen auslösen wird anhand von relevanten Ereignissen.

12. Methode gemäß einer der Ansprüche 8 - 11, worin einfache Signalverarbeitungsoperationen im Probesubmodul (8) durchgeführt sind, insbesondere durchschnittliche, filternde, entlärmende Zeit-Frequenz-Transformationen.

13. Methode gemäß einer der Ansprüche 8 - 12, worin ein Programm der Sensorfehlfeststellung zur Überprüfung der Sensorzurechnungsfähigkeit, Warnungserteilung oder Beendigung weiterer Handlungen im Falle einer Sensorfehlfunktion benutzt wird.

14. Methode gemäß einer der Ansprüche 8 - 13, worin die Datenkommunikation (12) zwischen der erfassten (7) und geprobten (8) physischen Daten und des darstellenden virtuellen Modells (24) der Struktur (2) asynchron ist, in dem genannte physische Daten in Datenspeicher (9) über eine Mission oder vordefinierten Zeitraum gesammelt und dann in das simulierte Modell (24) übertragen werden.

15. Methode gemäß einer der Ansprüche 8 - 14, worin eine integrierte und gleichzeitige Verwaltung der Gesundheitsstruktur von den mehreren Strukturen/Komponenten eines kritischen Systems durchgeführt ist.

## Revendications

1. Système de gestion de la santé structurelle, fondé sur des données d'intégrité simulée et physiques combinées de la structure critique (2), comprenant :

    a. un module physique (100) situé dans ladite structure (2), qui comprend un réseau de capteurs (1,3,4) monté ou intégré à ladite structure (2), où les positions des capteurs sont définies en utilisant l'optimisation de la réponse du capteur sur une gamme de fréquences, afin qu'ils captent un ensemble maximal de modes vibratoires, une plateforme du matériel (6), comprenant une acquisition de données (7) et des sous-modules de traitement (8) de signal et d'échantillonnage, avec une capacité à multi-capteurs, et une interface (5) pour la plateforme du matériel (6);
    b. un module virtuel (101), comprenant un modèle virtuel représentatif et simulé (24) de la structure (2), associé à un solveur approprié (15), capable de reproduire le comportement de la structure (2) et de ses composants, fondé sur l'information physique, recueillie du module physique (100);

où les sous-module d'échantillonnage (8) est configuré pour déclencher les données,
en recueillant les intervalles et la fréquence d'acquisition de données, fondées sur des valeurs prédéfinies ou sur un évènement sporadique mais pertinent.

2. Système selon la revendication 1, comprenant en outre :

    a. un sous-module de stockage de données (9) dans le module physique (100);
    b. une base de données (17) dans le module virtuel (101), configuré pour stocker et gérer les données, réelles ou simulées;
    c. un sous-module de décision (19) comprenant des sous-modules de diagnostics (20) et de pronostics (21) de la structure (2).

3. Système selon une quelconque revendication antérieure où les opérations de traitement de signe sont capables d'être effectuées dans le sous-module d'échantillonnage (8), en particulier, la réalisation de moyennes, le filtrage, les transformations temps-fréquence, ou le débruitage.

4. Système selon une quelconque revendication antérieure où les deux modules tant physique (100) que virtuel (101) sont tous deux montés ou intégrés dans ladite structure (2) et connectés à travers une connexion de données adaptée (12).

5. Système selon une quelconque revendication antérieure où le module virtuel (101) est monté hors de ladite structure (2) et est connecté au module physique (100) par une connexion de données adaptée (12).

6. Système selon une quelconque revendication antérieure où la connexion de données (12) entre les modules physiques (100) et virtuels (101) est asynchrone.

7. Système selon une quelconque revendication antérieure, comprenant en outre la gestion simultanée et intégrée de la santé structurelle d'un ensemble de systèmes critiques.

8. Méthode de gestion de la santé structurelle, fondée sur la combinaison entre les données d'intégrité simulées et physiques de la structure critique (2), comprenant les étapes suivantes:

    a. acquisition, échantillonnage et traitement de signe des données d'intégrité physique d'un module physique (100), comprenant un réseau de capteurs (1, 3, 4), monté ou intégré dans ladite structure (2), où les positions des capteurs sont définies en utilisant l'optimisation de la réponse du capteur sur une gamme de fréquences, afin qu'ils captent un ensemble maximal de modes vibratoires, une plateforme de matériel (6), comprenant l'acquisition de données (7) et des sous-modules de traitement de signe (8) et d'échantillonnage des sous-modules avec une capacité de multi-capteurs et d'une interface (5) à la plateforme de matériel (6);

    b. le calcul et la résolution, à l'aide d'un module virtuel (101) associé à un solveur (15), un modèle virtuel représentatif simulé (24) de la structure (2), reproduisant l'état physique de la structure (2) et de ses composants ;

    c. combination des données réelles des deux étapes antérieures à travers un algorithme d'optimisation du module virtuel (101) pour le diagnostic - la détection, la localisation et l'évaluation de la sévérité - du dommage structurel ou matériel,

où les réponses de capteur réel (1, 3, 4) sont vérifiées pour la détection de panne du capteur avant d'alimenter le modèle virtuel simulé (24), où ledit modèle simulé (24) était antérieurement établi lorsqu'il définissait les localisations optimales desdits capteurs (1, 3, 4); où le sous-module d'échantillonnage (8) déclenche des données, en recueillant des intervalles et une fréquence d'acquisition de données, fondées sur des valeurs prédéfinies ou sur un événement sporadique mais pertinent.

9. Méthode selon la revendication 8, comprenant en outre les étapes suivantes:

    a. stockage (9) des données acquises (7) et échantillonnées (8);
    b. détection des défaillances de capteurs et des dommages au sein du module physique (100), au niveau de l'acquisition de données (7) et/ou au module virtuel (101), au niveau de la traduction de données (14), avant la saisie de données dans le sous-module RVM (24);
    c. traduction vers un format approprié pour l'entrée au sein du modèle simulé (24), des données acquises (7), échantillonnées (8) et vérifiées ;
    d. détermination du diagnostic (20) et du pronostic (21) de la structure (2), fondée sur ledit modèle simulé (24) ;
    e. sortie (22) desdits diagnostics (20) et des pronostics (21) de la structure (2).

10. Méthode selon une quelconque revendication antérieure 8 - 9, où le sous-module d'échantillonnage (8) déclenchera des intervalles de recueil de données et une fréquence d'acquisition de données, en se fondant sur des valeurs prédéfinies.

11. Méthode selon une quelconque revendication antérieure 8 - 10, où le sous-module d'échantillonnage (8) déclenchera des intervalles de recueil de données, en se fondant sur des événements pertinents.

12. Méthode selon une quelconque revendication antérieure 8 - 11, où les opérations de traitement de signe simple sont effectuées au sein du sous-module d'échantillonnage (8), notamment par la réalisation de moyennes, le filtrage, les transformations temps-fréquence, le débruitage.

13. Méthode selon une quelconque revendication antérieure 8 - 12, où un outil de détection d'erreur de capteurs est utilisé afin de vérifier la santé du capteur, émettant des alertes ou des arrêts d'actions supplémentaires en cas de mauvais fonctionnement du capteur.

**14.** Méthode selon une quelconque revendication antérieure 8 - 13, où la communication de données (12) entre les données physiques acquises (7) et échantillonnées (8) et le modèle virtuel représentatif (24) de la structure (2) est asynchrone avec lesdites données physiques collectées dans le stockage de données (9) au cours d'une mission ou d'une période de temps prédéfinie et ensuite étant transférées au sein du modèle simulé (24).

**15.** Méthode selon une quelconque revendication antérieure 8 - 14, où une gestion intégrée et simultanée de la santé structurelle de plusieurs structures/composants du système critique est effectuée.

**Figure 1**

Figure 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1455313 A1, Kent
- US 7260501 B2, Pattipatti
- US 20060259217 A1, Gorinevsky
- US 20060004499 A1, Trego
- US 20090070048 A
- US 20100162825 A
- US 20100169251 A